# EUROPÄISCHE PATENTSCHRIFT

(11) **EP 1 004 028 B1**
(45) Veröffentlichungstag und Bekanntmachung des Hinweises auf die Patenterteilung: **08.05.2002**
(21) Anmeldenummer: 98948769.9
(22) Anmeldetag: 11.08.1998
(51) Int. Cl.: G01R 11/04, G01R 22/00, G08C 23/04

(54) **ZÄHLER**
COUNTER
COMPTEUR

(30) Priorität: 12.08.1997 DE 19734892
(43) Veröffentlichungstag der Anmeldung: 31.05.2000
(73) Patentinhaber: SIEMENS AKTIENGESELLSCHAFT, 80333 München (DE)
(72) Erfinder: WINDSHEIMER, Klaus, D-91174 Spalt (DE)
(86) Internationale Anmeldenummer: DE9802311
(87) Internationale Veröffentlichungsnummer: WO9908118

(56) Entgegenhaltungen:
- EP-A- 0 508 100
- EP-A- 0 752 589
- DE-A- 4 139 011
- US-A- 4 887 312

## Beschreibung

Die Erfindung betrifft einen Zähler mit einem verplombbaren Gehäuse, in welchem eine Zähleinrichtung angeordnet ist, und mit einem Display, welches außerhalb des Gehäuses angeordnet ist.

Ein derartiger Zähler ist aus der EP 0 752 589 A1 bekannt. Gegebenenfalls kann das Gehäuse verplombt sein. Damit ist ein Austausch des Displays ohne unbefugtes Öffnen des Gehäuses möglich. Das Display an sich stellt nämlich dort gemäß Definition nicht eine eichpflichtige Komponente des Zählers dar. Das Display ist dabei über eine Steckerleiste, also mittels einer galvanischen Verbindung, mit der Elektronik des Zählers verbunden. Eine völlige Rückwirkungsfreiheit beim Austausch des Zählers, z.B. durch Kurzschluß usw., ist daher nicht gewährleistet.

Der Erfindung liegt daher die Aufgabe zugrunde, einen Zähler mit einem austauschbaren Display anzugeben, bei dem der Austausch und die Rückwirkungsfreiheit verbessert sind.

Die Lösung der Aufgabe gelingt erfindungsgemäß mit einem Zähler mit einem verplombbaren Gehäuse, in welchem eine Zähleinrichtung angeordnet ist, und mit einem Displaymodul, welches außerhalb des Gehäuses angeordnet ist. Zwischen dem Displaymodul und der Zähleinrichtung ist eine optische Schnittstelle geschaltet, wobei die optische Schnittstelle zumindest teilweise zur Energieversorgung für das Displaymodul dient.

Auf diese Weise ist eine nahezu vollständige Rückwirkungsfreiheit auf den Meßteil des Zählers gegeben. Die optische Schnittstelle dient als galvanische Trennung und gleichzeitig zur Energieversorgung. Bevorzugt dient die Energieversorgung über die optische Schnittstelle nur für einen Speicher des Displaymoduls, so daß eine Datensicherung gewährleistet und ein Datenverlust vermieden sind.

Auf diese Weise ist nur ein geringer Energiebedarf des Displaymoduls zu decken, wobei auf jeden Fall relevante Daten für die Ausgabe gesichert sind. Die energietechnische Belastung der optischen Schnittstelle ist dabei sehr gering gehalten.

Mit Vorteil kann das Displaymodul als Display ein Anzeigeelement, z. B. eine LCD-Anzeige, und eine erste Solarzelle für deren Energieversorgung umfassen. Die erste Solarzelle ist dabei von einer externen Lichtquelle mit Licht versorgbar. Damit ist die Energieversorgung des Anzeigeelements oder des Displays von der des Zählers getrennt und somit autark. Bei normalem Tageslicht ist der Zähler somit ohnehin ablesbar. Ist normales Umgebungslicht nicht vorhanden oder nicht ausreichend, so kann eine Aktivierung des Displays durch eine zusätzliche Lichtquelle, z. B. durch eine Taschenlampe, erfolgen.

Es ist günstig, wenn die optische Schnittstelle gehäuseseitig eine Leuchtdiode und displaymodulseitig eine zweite Solarzelle umfaßt, wobei die zweite Solarzelle an einer dem Gehäuse zugewandten Seite und die erste Solarzelle an einer dem Gehäuse abgewandten Seite des Displaymoduls angeordnet sind. Die optische Schnittstelle ist somit in einem geschützten, also von Fremdlicht abgeschirmten Bereich untergebracht, während die erste Solarzelle für einen Bediener leicht zugänglich, nämlich an der Vorderfront des Gehäuses, angebracht ist.

Mit Vorteil weist das Gehäuse eine Haltevorrichtung zur Aufnahme des Displaymoduls auf. Diese kann gegebenenfalls auch als Einschubvorrichtung oder auch gegebenenfalls als Moduleinsteckplatz ausgebildet sein. Gegebenenfalls kann auch zusätzlich eine Abdeckung für das Displaymodul vorgesehen sein, die dieses und den dahinterliegenden Bereich des Gehäuses schützend umgibt. Die Abdeckung kann zusätzlich eine Versiegelung oder eine entsprechende Lasche zur Anbringung einer Plombe umfassen, so daß hier gegebenenfalls durch den Anwender selbst, z.B. ein EVU oder Industriekunden, eine eigene Verplombung des Displaymoduls vorgenommen werden kann.

Die Zähleinrichtung kann zum Zählen elektrischer Energie, einer Durchflußmenge einer Wärmemenge oder einer sonstigen Energiemenge dienen. Bei derartigen Zähleinrichtungen treten die Vorteile der Erfindung wesentlich zutage. Dies gilt insbesondere im Hinblick darauf, daß innerhalb des Gehäuses, welches verplombbar ist, eichpflichtige Komponenten angeordnet sind. Das Displaymodul stellt unter bestimmten Bedingungen nicht eine solche Komponente dar. Es dient nämlich lediglich zur Datenausgabe und hat keinerlei Rückwirkungsmöglichkeit auf die Energiemessung an sich. Damit ist das Displaymodul auch einfach austauschbar. Es handelt sich dabei um ein rein passives Modul im Hinblick auf die Datenausgabe der Zähleinrichtung.

Ein Ausführungsbeispiel der Erfindung, weitere Vorteile und Details werden nachfolgend anhand der Zeichnung näher erläutert. Es zeigen:
- Figur 1: einen Zähler in einer räumlichen Darstellung und
- Figur 2: ein Blockschaltbild eines Zählers.

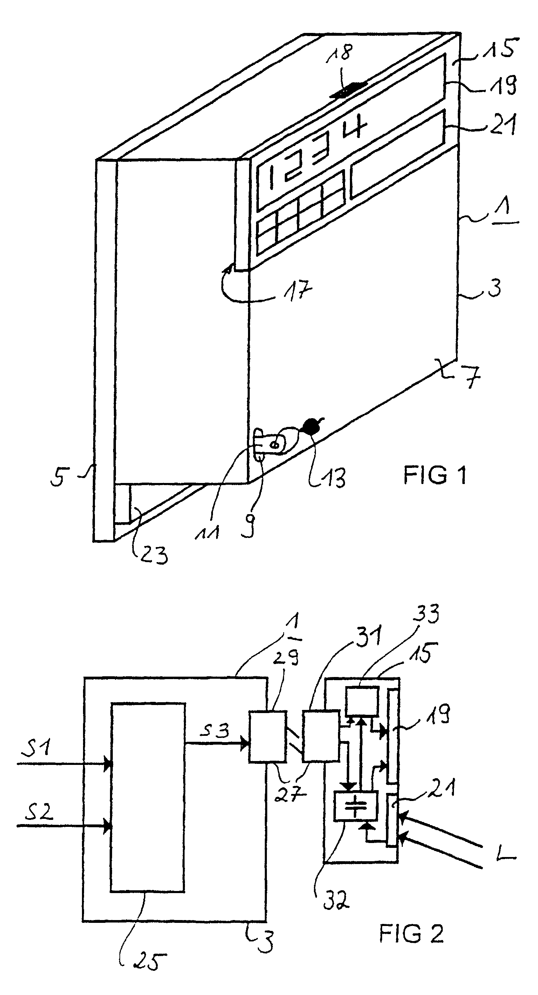

Figur 1 zeigt einen Zähler 1 in einer räumlichen Darstellung. Es kann sich dabei um einen beliebigen Zähler zum Zählen einer beliebigen Energiemenge, z. B. einer Durchflußmenge einer Wärmemenge oder elektrischer Energie, handeln. Vorliegend wird rein beispielhaft auf eine Ausführung zur Zählung elektrischer Energie Bezug genommen.

Der Zähler 1 weist ein Gehäuse 3 auf, welches ein Bodenteil 5 und einen Gehäusedeckel 7 umfaßt. Der Gehäusedeckel 7 ist dabei beispielsweise mittels nicht näher dargestellter Befestigungsmittel, z. B. Schrauben oder einer Klemmeinrichtung, mit dem Bodenteil 5 verbindbar.

Da innerhalb des Gehäuses 3 eichpflichtige Komponenten enthalten sein können, weist der Gehäusedeckel 7 eine Öffnung 9 auf, durch die eine Lasche 11 des Bodenteils 5 hindurchgeführt ist. An dieser Lasche 11 kann wie dargestellt eine Eichplombe 13 befestigt werden, so daß ein unerlaubtes Öffnen des Gehäuses 3 erkannt werden kann.

Außerhalb des Gehäusedeckels 7 ist ein Displaymodul 15 angeordnet. Dieses kann auf verschiedene Arten und Weisen am Gehäusedeckel 7 angeordnet sein. Vorliegend ist es in einer Aussparung 17 angeordnet, die zusammen mit einem Rastgriff 18 als Haltevorrichtung für das Displaymodul 15 dient.

Das Displaymodul 15 weist ein Display 19 als Anzeigeelement auf, welches beispielsweise als LCD-Anzeigeelement ausgebildet sein kann. Zusätzlich umfaßt das Displaymodul 15 frontseitig eine erste Solarzelle 21. Auf die nähere Funktion des Displaymoduls 15 mit seinen Elementen im Zusammenhang mit einer nicht näher dargestellten, im Gehäuse 3 angeordneten Zähleinrichtung wird nachfolgend anhand der Figur 2 näher eingegangen.

Bei Ausbildung des Zählers 1 als Elektrizitätszähler weist dieser wie dargestellt eine Klemmleiste 23 auf, an die die zur Messung erforderlichen Signale angeschlossen werden können.

Figur 2 zeigt den Zähler 1 in einer Blockdarstellung. Innerhalb seines Gehäuses 3 ist die bereits oben schon erwähnte Zähleinrichtung 25 angeordnet, die beispielsweise einen Mikroprozessor, Analog-/Digitalwandler oder auch digitale Signalprozessoren umfassen kann. Eingangsseitig werden dazu der Zähleinrichtung 25 die erforderlichen Meßgrößen, vorliegend rein beispielhaft die Signale S1 und S2, zugeführt. Im Falle einer elektrischen Energiemessung können dies z. B. Strom und Spannung sein. Im Falle einer Wärmemenge könnten diese Signale beispielsweise auch eine Durchflußmenge und eine Temperatur sein.

Die gemessene Energiemenge wird als Energiesignal S3 an eine optische Schnittstelle 27 geleitet, die eine Informationsübertragung von der Zähleinrichtung 25 zum Displaymodul 15 erlaubt. Die optische Schnittstelle 27 weist gehäuseseitig ein Sendemittel, insbesondere eine Leuchtdiode 29, auf, das auf ein am Displaymodul 15 angeordnetes Empfangsmittel, insbesondere eine zweite Solarzelle 31, ausgerichtet ist.

Die zweite Solarzelle 31 ist ausgangsseitig mit einem Speicher 33 verbunden. Damit können die im Signal S3 enthaltenen Informationen, insbesondere über eine verbrauchte Energiemenge, in den Speicher 33 eingelesen werden.

Dieser Anordnung kommt eine weitere Funktion zu. Die durch das Signal S3 über die Leuchtdiode 29 an die zweite Solarzelle 31 übertragene Information wird Energie übertragen. Diese Energie wird vorliegend dazu genutzt, zumindest den Speicher 33 zu betreiben. Auf diese Weise gelangen die verbrauchsrelevanten Daten in das autarke Displaymodul 15 ohneweitere Energieversorgung. Die zweite Solarzelle 31 ist dazu mit einer Energieversorgungseinrichtung 32 verbunden, welche gegebenenfalls wie angedeutet einen Energiespeicher, z.B. einen Kondensator oder einen Batterie, umfassen kann.

Ist die von der zweiten Solarzelle 31 erhaltene Energiemenge ausreichend, so kann diese auch zum Betrieb des Displays 19 verwendet werden. Ist dieses jedoch nicht der Fall, so kann für das Display 19 eine weitere Energieversorgung vorgesehen werden.

Der Einfachheit halber ist dazu frontseitig am Displaymodul 15 eine erste Solarzelle 21 angeordnet, die mit einer externen Lichtquelle, z. B. Umgebungslicht (Lichtstrahlen L), oder einem zusätzlichen Licht, insbesondere einer Taschenlampe, mit Energie versorgbar ist. Auf diese Weise kann das Display 19 zum Ablesen durch einen Bediener mittels der externen Lichtquelle aktiviert werden, wobei es keinen Einfluß auf den Speicher 33 oder gegebenenfalls auf eine weitere Verarbeitungseinrichtung innerhalb des Displaymoduls 15 geben muß.

Die Energieverteilung von der ersten Solarzelle 21 zum Speicher 33 und dem Display 19 und/oder auch gegebenenfalls weiteren aktiven Verarbeitungseinrichtungen innerhalb des Displaymoduls 15 erfolgt durch die Energieversorgungseinrichtung 32 nach Art eines Netzteils. Sie weist dazu eine entsprechende elektrische Schaltung, z.B. mit Entkoppeldioden für die Solarzellen, auf.

Wie Figur 2 klar zeigt, ist hier lediglich eine Signalrichtung von dem Gehäuse 3 zum Displaymodul 15 vorhanden. Die Zähleinrichtung 25 ist dadurch rückwirkungsfrei geschützt. Damit kann das Displaymodul 15 im Reparatur- oder Wartungsfall einfach ausgetauscht werden. Gegebenenfalls ist zum Ablesen das Displaymodul 15 sogar einfach abnehmbar, was das Ablesen erheblich vereinfacht. Für diesen Fall kann gegebenenfalls eine Pufferbatterie oder ein sonstiger elektrischer Speicher zum Betrieb des Speichers 33 - wie bereits angedeutet - vorgesehen sein.

Gegebenenfalls kann, wie in Figur 1 dargestellt, das Displaymodul 15 auch ein Tastenfeld aufweisen, das zum Abruf oder zur Aktivierung verschiedenster Ablesefunktionen innerhalb des Displaymoduls 15 dient. Dabei ist insbesondere an den Abruf verschiedener Energiewerte, z. B. Maximum- oder Minimumwerte, Blind- oder Wirkleistung und an eine Reset-Funktion zum Zurücksetzen des Speichers 33 gedacht.

## Patentansprüche

1. Zähler (1) mit einem verplombbaren Gehäuse (3), in welchem eine Zähleinrichtung (25) angeordnet ist, und mit einem Displaymodul (15), welches außerhalb des Gehäuses (3) angeordnet ist, **dadurch gekennzeichnet, daß** zwischen dem Displaymodul (15) und der Zähleinrichtung (25) eine optische Schnittstelle (27) geschaltet ist und daß die optische Schnittstelle zumindest teilweise zur Energieversorgung für das Displaymodul (15) dient.

2. Zähler nach Anspruch 1, wobei die Energieversorgung für einen Speicher (33) des Displaymoduls (15) erfolgt.

3. Zähler nach Anspruch 1 oder 2, wobei das Displaymodul (15) eine erste Solarzelle (21) zumindest für die Energieversorgung des Displays (19) des Displaymoduls (15) umfaßt, wobei die erste Solarzelle (21) von einer externen Lichtquelle mit Licht versorgbar ist.

4. Zähler nach Anspruch 3, wobei die optische Schnittstelle (27) gehäuseseitig eine Leuchtdiode (29) und displaymodulseitig eine zweite Solarzelle (31) umfaßt, wobei die zweite Solarzelle (31) an einer dem Gehäuse (3) zugewandten Seite und die erste Solarzelle (21) an einer dem Gehäuse (3) abgewandten Seite des Displaymoduls (15) angeordnet sind.

5. Zähler nach einem der Ansprüche 1 bis 4, wobei das Gehäuse (3) eine Haltevorrichtung zur Aufnahme des Displaymoduls (15) aufweist.

6. Zähler nach einem der Ansprüche 1 bis 5, wobei die Zähleinrichtung (25) zum Zählen von elektrischer Energie, einer Durchflußmenge, einer Wärmemenge oder einer sonstigen Energiemenge dient.

## Claims

1. Meter (1) having a housing (3) which can be lead-sealed and in which a metering device (25) is arranged, and having a display module (15) which is arranged outside the housing (3), **characterized in that** an optical interface (27) is connected between the display module (15) and the metering device (25) and **in that** the optical interface is used at least partially for the power supply for the display module (15).

2. Meter according to Claim 1, the power supply being provided for a memory (33) in the display module (15).

3. Meter according to Claim 1 or 2, in which case the display module (15) includes a first solar cell (21) at least for the power supply for the display (19) in the display module (15) and in which case the first solar cell (21) can be supplied with light from an external light source.

4. Meter according to Claim 3, in which case the optical interface (27) includes a light-emitting diode (29) on the housing side and a second solar cell (31) on the display module side, in which case the second solar cell (31) is arranged on a side of the display module (15) facing the housing (3), and the first solar cell (21) is arranged on a side of the display module (15) facing away from the housing (3).

5. Meter according to one of Claims 1 to 4, in which case the housing (3) has a retaining apparatus for accommodating the display module (15).

6. Meter according to one of Claims 1 to 5, in which case the metering device (25) is used for metering electrical energy, a flow rate, heat usage or any other energy usage.

## Revendications

1. Compteur (1) ayant un boîtier (3) qui peut être plombé et dans lequel est disposé un dispositif (25) compteur et comprenant un module (15) d'affichage qui est disposé à l'extérieur du boîtier (3), **caractérisé en ce qu'**il est monté entre le module (15) d'affichage et le dispositif (25) compteur une interface (27) optique et **en ce que** l'interface optique sert au moins en partie à alimenter le module (15) d'affichage en énergie.

2. Compteur suivant la revendication 1, dans lequel l'alimentation en énergie alimente une mémoire (33) du module (15) d'affichage.

3. Compteur suivant la revendication 1 ou 2, dans lequel le module (15) d'affichage comprend une première pile (21) solaire au moins pour l'alimentation en énergie de l'affichage (19) du module (15) d'affichage, la première pile (21) solaire pouvant être alimentée en lumière par une source extérieure de lumière.

4. Compteur suivant la revendication 3, dans lequel l'interface (27) optique comprend, du côté du boîtier, une diode (29) électroluminescente et, du côté du module d'affichage, une deuxième (31) solaire, la deuxième pile (31) solaire étant disposée sur un côté du module (15) d'affichage qui est tourné vers le boîtier (3) et la première pile (21) solaire étant disposée d'un côté du module (15) d'affichage qui est éloigné du boîtier (3).

5. Compteur suivant l'une des revendications 1 à 4, dans lequel le boîtier (3) comporte un dispositif de maintien destiné à la réception du module (15) d'affichage.

6. Compteur suivant l'une des revendications 1 à 5, dans lequel le dispositif (25) compteur sert à compter de l'énergie électrique, un débit, une quantité de chaleur ou une autre quantité d'énergie.
